Europäisches Patentamt

European Patent Office

Office européen des brevets

(11) Numéro de publication: **0 443 484 A1**

# DEMANDE DE BREVET EUROPEEN

(21) Numéro de dépôt: 91102265.5

(22) Date de dépôt: **18.02.91**

(51) Int. Cl.5: **H01P 5/04**, H03F 3/60, H03F 1/52

(30) Priorité: 23.02.90 FR 9002279

(43) Date de publication de la demande:
**28.08.91 Bulletin 91/35**

(84) Etats contractants désignés:
**DE ES FR GB IT NL SE**

(71) Demandeur: **ALCATEL TRANSMISSION PAR FAISCEAUX HERTZIENS A.T.F.H.**
**55, rue Greffulhe**
**F-92301 Levallois-Perret Cédex(FR)**

(72) Inventeur: **Cruchon, Jean-Claude**
**28, rue Ney**
**F-95570 Bouffemont(FR)**
Inventeur: **Schubert, Jean-Denis**
**4, Allée des Tilleuls**
**F-78480 Verneuil-sur-Seine(FR)**

(74) Mandataire: **Weinmiller, Jürgen et al**
**Lennéstrasse 9 Postfach 24**
**W-8133 Feldafing(DE)**

(54) **Liaison de puissance, protégée par redondance, pour signaux hyperfréquence.**

(57) Liaison de puissance en hyperfréquence, utilisant une ou plusieurs paires d'amplificateurs (32, 29) en redondance active.

Un Coupleur à Rang Variable, avec coupleurs RIBBLET (7, 13) et déphaseur (12), est prévu pour connecter les deux amplificateurs (32, 29) sur une sortie unique (4). Cette configuration permet la connexion aisée de plusieurs paires d'amplificateurs redondants, ainsi que l'utilisation de techniques à microruban ou coaxiale.

FIG 4

La présente invention se rapporte à une liaison de puissance pour signaux hyperfréquence, cette liaison étant protégée par redondance, par exemple grâce à l'utilisation de plusieurs amplificateurs de puissance fonctionnant en redondance active.

Au niveau des émetteurs de puissance équipant par exemple les stations terriennes, il est souvent nécessaire d'utiliser des liaisons qui soit réalisent un couplage entre des voies séparées, soit tendent à regrouper plusieurs émetteurs de puissance sur un seul accès de sortie, c'est à dire en fait sur l'antenne d'émission. Par ailleurs, il est actuellement généralement exigé, afin que la liaison soit protégée contre les pannes d'amplificateurs de puissance, que cette liaison utilise des amplificateurs de puissance redondants.

Dans ce but, les émetteurs les plus courants utilisent un amplificateur principal, normalement actif, et prévoient en outre une autre voie d'amplification comportant un autre amplificateur identique au premier, cette seconde voie étant apte à être commutée à la place de la première en cas de défaillance de cet amplificateur principal. En général, afin d'éviter une perte d'information trop importante en cas de commutation sur cet amplificateur de secours, ce dernier est constamment maintenu sous tension, en état de veille : on dit alors qu'il fonctionne en redondance "chaude".

Comme on le conçoit bien, ce genre de dispositif classique a pour inconvénient d'être onéreux, puisqu'il oblige à prévoir deux chaînes d'amplification identiques en parallèle, dont l'une d'elles ne fonctionne qu'en cas de panne ou de déconnexion de la première.

Pour remédier à cet inconvénient, on tend à s'orienter sur des installations fonctionnant en redondance "active" : il s'agit d'installations qui comportent deux amplificateurs, chacun à moitié de la puissance nominale, qui fonctionnent en permanence et en parallèle. En cas de panne de l'un des deux, l'autre continue à fonctionner, de sorte que la liaison est assurée de toute façon dans ce cas, à puissance inférieure à la puissance nominale toutefois, mais ceci est sans inconvénient rédhibitoire compte-tenu des marges de tolérance classiquement adoptées pour ces amplificateurs de puissance.

Il existe dans le commerce des dispositifs de liaison de ce type, mais ces dispositifs, du fait que le couplage des deux amplificateurs redondants sur l'antenne d'émission est réalisé en guides d'ondes et par l'utilisation de transducteurs "orthomodes" ("Ortho-Mode-Transducers) associés à un déphaseur en guide circulaire TE11, présentent deux inconvénients :

.  il n'est ainsi possible de ne réaliser simplement que des liaisons de puissance utilisant deux amplificateurs en redondance active, et non pas quatre, six, huit, ou plus : l'entrée sur transducteurs orthomodes utilise en effet deux guides rectangulaires et orthogonaux, de sorte que la mise en parallèle de plus de deux amplificateurs poserait, pour leur regroupement en "pyramide", de délicats et onéreux problèmes de compensation de chemins de phase ;

.  cette technique pour transducteurs orthomodes est une technique purement "guides d'ondes" : elle n'a pas son équivalent direct en technique coaxiale ou en technique à microrubans ("microstrips"), de sorte que ces installations ne peuvent être transposées dans ces deux dernières techniques, ce qui serait pourtant souhaité dans certains cas où l'on fonctionne à puissance d'émission peu élevée.

L'invention vise à remédier à ces derniers inconvénients. Elle se rapporte à cet effet à une liaison de puissance pour signaux hyperfréquence, cette liaison étant protégée par redondance, en particulier par l'utilisation de plusieurs amplificateurs de puissance fonctionnant en redondance active, caractérisée en ce qu'elle comporte au moins :

.  un coupleur 3dB, 0° apte à diviser le signal d'entrée à amplifier en une ou plusieurs paires de signaux synchrones en fréquence et en phase ;

.  un circulateur d'adaptation suivi d'un amplificateur de puissance sur chacune des voies correspondant à chacun de ces signaux ; un déphaseur "0 ou " étant disposé sur l'une des voies de chaque paire avant le circulateur d'adaptation ; et

.  un "Coupleur à Rang Variable" associé à chaque paire de voies en aval de ces deux amplificateurs qu'elle comporte et comprenant en cascade :

- un coupleur d'entrée 3dB, 90° dont les deux bornes d'entrée sont respectivement attaquées par les deux signaux provenant des sorties respectives de ces deux amplificateurs ;

- un déphaseur réglable, apte à réaliser un déphasage allant de 0° à 180°, placé sur une des deux voies de sortie de ce coupleur d'entrée ; et

- un coupleur de sortie 3dB, 90° semblable ou identique au coupleur d'entrée et dont les deux voies d'entrée sont respectivement attaquées par le signal de sortie de ce déphaseur réglable et par le signal provenant de l'autre voie de sortie du coupleur d'entrée, et dont une borne de sortie est connectée sur une charge tandis que l'autre borne de sortie soit constitue la sortie de puissance de la liaison, soit attaque à son tour une des deux bornes d'entrée d'un autre Coupleur à Rang Variable.

De toute façon, l'invention sera bien comprise, et ses avantages et autres caractéristiques ressortiront, lors de la description suivante d'un exemple non limitatif de réalisation de cette liaison redondante, en référence au dessin schématique annexé dans lequel :

- Figure 1 rappelle la constitution d'un coupleur à rang variable de l'art connu ;
- Figure 2 est une coupe transversale d'un des coupleurs "RIBBLET" utilisable dans un coupleur à rang variable selon Figure 1 ;
- Figure 3 est une section transversale médiane du coupleur selon Figure 2, montrant la forme des ondes engendrées dans cette section en cas d'utilisation de ce coupleur de façon conforme à l'invention ;
- Figure 4 est un schéma synoptique de l'installation de puissance conforme à l'invention, avec seulement une paire d'amplificateurs en redondance active ; et
- Figure 5 montre l'extension du schéma selon Figure 4 à une installation comportant plusieurs paires d'amplificateurs en redondance active.

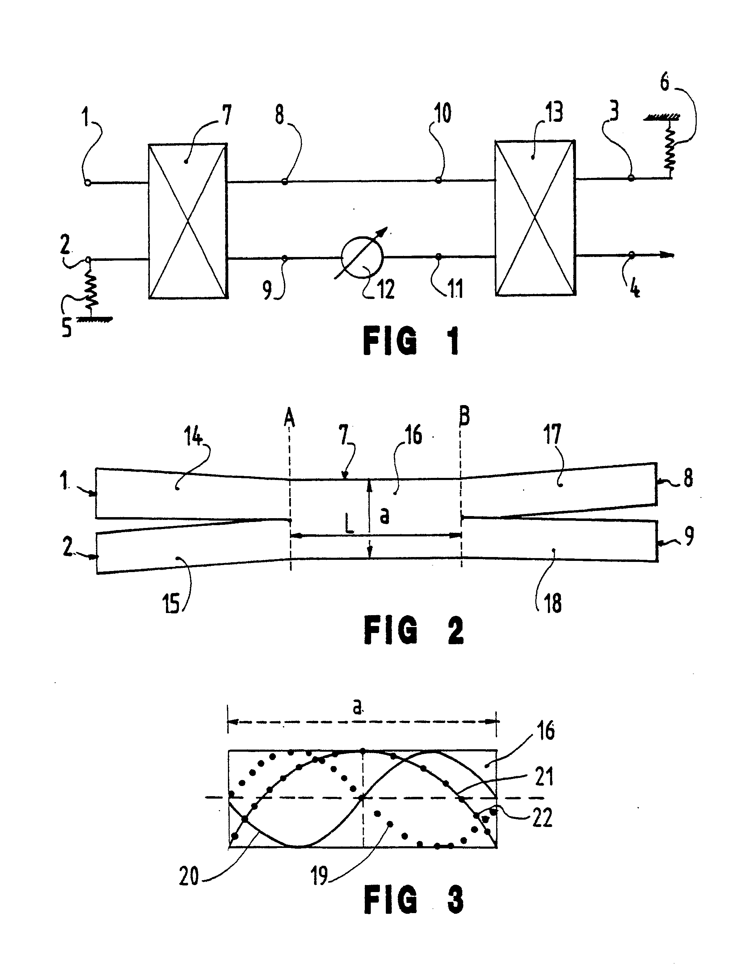

Sur la figure 1 est représentée un composant connu, appelé "Coupleur à Rang Variable", ou "C.R.V.", qui est le composant de base pour la mise en oeuvre de la présente invention.

Ce C.R.V. est un quadripôle qui comporte deux bornes d'accès amont 1, 2, pouvant être considérées comme les bornes d'entrée et deux bornes aval 3, 4 qui peuvent être considérées comme les bornes de sortie du quadripôle. Dans l'utilisation courante de ce composant C.R.V., les bornes 2 et 3 sont reliées à la masse par les résistances de charge respectives 5 et 6, de sorte que le signal hyperfréquence d'entrée est appliqué en 1, tandis que le signal de sortie est prélevé en 4.

Les bornes 1 et 2 sont les deux bornes amont d'un coupleur "3dB-90°", référencé 7, qui est classiquement un coupleur RIBBLET (figure 2). Ce coupleur RIBBLET est tel que le signal appliqué en 1 donne, en sorties 8 et 9 de ce coupleur 7, deux signaux respectivement déphasés de 0° et 90°, et d'amplitude moitié de ce signal d'entrée.

Le signal en 8 est appliqué à l'entrée 10 d'un second coupleur RIBBLET 13 identique au coupleur 7, l'autre entrée 11 de ce dernier n'étant pas chargée vers la masse, mais étant reliée à la sortie 9 du coupleur 7 par l'intermédiaire d'un déphaseur hyperfréquence réglable 12. Les bornes 3 et 4 précitées sont aussi les deux bornes aval de ce coupleur 13.

Dans son utilisation la plus classique, le C.R.V. de la figure 1 est un circuit à pertes apte par exemple à sélectionner une fréquence $F_1$ parmi deux fréquences d'entrée $F_1$, $F_2$.

L' invention se base sur l'utilisation d' une propriété particulière d'un coupleur "3dB-90°", tel que le coupleur RIBBLET 7 de la figure 2, propriété qui va être énoncée et démontrée comme suit, en référence aux figures 2 et 3 :

Ce coupleur 7 possède, contigus aux accès 1 et 2, deux premiers tronçons identiques 14, 15 en guide rectangulaire, qui débouchent dans un tronçon médian 16 en guide rectangulaire de largeur a (grand côté du guide), et de longueur 1, ce tronçon 16 débouchant sur deux autres tronçons 17 et 18 identiques aux tronçons 14 et 15 et sortant en 8 et 9. La dimension a diffère assez peu de la somme des largeurs des guides 14 et 15 (ou 17 et 18)

En utilisation classique de ce coupleur 7, une d'onde est appliquée à l'un des accès 1 ou 2, et, dans le plan A (figure 2), deux modes de propagation d'égales amplitudes existent, avec des vitesses de phase toutefois différentes. Il s'agit :

. d'un mode symétrique TE01 de longueur d'onde guidée :

$$\lambda_{g01} = \frac{\lambda}{\sqrt{1 - (\lambda/2a)^2}}$$

où $\lambda$ est la longueur d'onde de l'ordre appliquée en 1 ou 2 ; et

. d'un mode antisymétrique TE02 de longueur d'onde guidée :

$$\lambda_{g02} = \frac{\lambda}{\sqrt{1 - (\lambda/a)^2}}$$

Dans le plan B, après parcours de la longueur L (figure 2), le déphasage relatif de ces deux ondes est de :

$$\Delta\varphi = 2\pi L \left( \frac{1}{\lambda_{g02}} - \frac{1}{\lambda_{g01}} \right)$$

ce qui donne naissance à deux ondes en quadrature si L est choisie pour que ce déphasage relatif soit égal à $\pi/2$.

Ainsi, lorsqu'une onde attaque l'accès 1, on trouvera en 8 une onde d'amplitude moitié et non-déphasée, et en 9 une onde d'amplitude moitié et déphasée de 90°.

Si maintenant deux ondes en phase attaquent les accès 1 et 2, on trouvera dans un plan de jonction 16 (plan A par exemple), la composition de quatre ondes (figure 3), dont :

. deux ondes antisymétriques 19 et 20, en mode TEO2, qui se détruisent par opposition de phase ; et

. deux ondes symétriques 21 et 22, en mode TEO1, qui se somment en phase.

Il s'ensuit que ce coupleur 7 se comporte, pour deux ondes d'entrée synchrones en fréquence et en phase, comme deux guides parallèles.

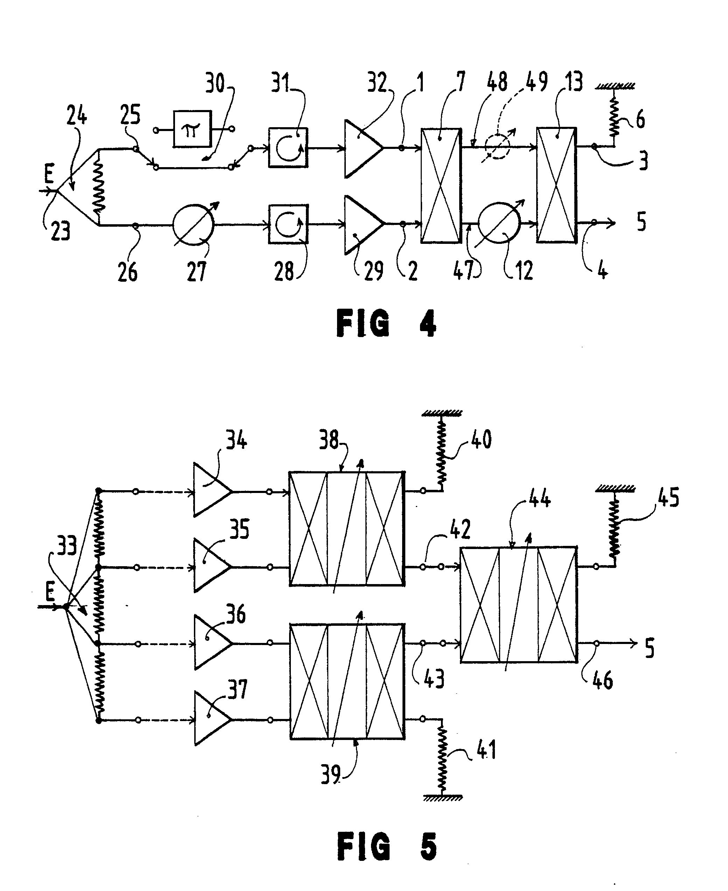

On se reportera maintenant à la figure 4, qui montre une chaîne d'amplification, conforme à l'invention, en redondance active d'ordre 2.

Le signal hyperfréquence à émettre E est appliqué sur l'entrée 23 d'un coupleur "3dB-0°" tel qu'un coupleur WILKINSON 24.

Deux signaux synchrones mais d'amplitudes moitié apparaissent donc sur les sorties 25 et 26 de ce coupleur.

Le signal en 26 passe au travers d'un petit déphaseur réglable 27, optionnel, qui a pour rôle de parfaire le synchronisme de phase des deux ondes émises en 25 et 26, puis au travers d'un circulateur d'adaptation 28 pour être finalement appliqué à un premier amplificateur de puissance 29.

Le signal en 25 passe par un déphaseur "O ou π" 30, puis par un autre circulateur d'adaptation 31, pour être finalement appliqué au second amplificateur de puissance 32, identique à l'amplificateur 29.

Les amplificateurs 29 et 32 sont les deux amplificateurs en redondance active de la liaison selon la figure 4.

Les sorties des amplificateurs 32 et 29 sont respectivement appliquées aux entrées 1 et 2 d'un C.R.V. (7, 12, 13) identique à celui de la figure 1, mais dont la borne 2 n'est pas chargée vers la masse.

Dans cet exemple préférentiel de réalisation, le déphaseur 12 du C.R.V. est seulement apte à réaliser un déphasage allant de 0° à 180° (ce qui ne pose pas les difficiles et onéreux problèmes de réalisation d'un déphaseur qui irait de 0° à 360°). Le fonctionnement du dispositif de la figure 4 est alors le suivant :

Au cas où le déphaseur "O° ou 180°" 30 est en position de déphasage 0° (commutateurs ayant la position de la figure 4), les deux ondes en 1 et 2 se somment intégralement en phase sur la borne 4 (sortie S de la liaison), et aucun signal n'apparaît en 3 (charge 6), sous condition que le déphasage dû à 12 soit égal à 90°.

Si l'on fait alors croître le déphasage dû à 12 entre 90° et 180°, l'onde en 4 décroît et celle en 3 croît, pour atteindre respectivement la moitié de la puissance initiale lorsque ce déphasage atteint 180°.

Si à contrario on fait décroître ce déphasage entre 90° et 0°, l'onde en 4 décroît et celle en 3 croît, pour atteindre de même la demi-puissance à chacun de ces deux accès de sortie lorsque ce déphasage parvient à 0°.

Dans la position du déphaseur 30 correspondant à un déphasage de π(position de commutateurs de 30 inverse de celle de la figure 4), on bascule tout le signal sur l'accès 3, rien ne sortant en 4, sous condition que le déphaseur 12 fournisse un déphasage de 90 degrés (on obtiendrait le même résultat sans déphaseur 30, mais en utilisant un déphaseur 12 couvrant une plus large gamme, ce qui serait bien plus complexe et onéreux à réaliser).

La liaison de la figure 4 présente donc une infinie souplesse d'utilisation et elle se prête aisément à la réalisation de redondances supérieures à 2, puisque la sortie 4 s'effectue en guide rectangulaire apte à attaquer directement le coupleur RIBBLET d'un autre C.R.V. A titre illustratif, la figure 5, à laquelle on se reportera maintenant, montre un exemple de réalisation d'une liaison en redondance active d'ordre 4.

Sur cette figure 5, il et prévu 4 amplificateurs de puissance redondants 34 à 37 qui sont pareillement alimentés par le signal d'entrée E à travers un diviseur par quatre 33, et deux fois deux circuits tels que (30, 31, 27, 28), non représentés.

Les amplificateurs 34 et 35 attaquent, de même façon qu'en figure 4, un C.R.V. 38, chargé par la résistance 40 et sortant en 42, tandis que les amplificateurs 36 et 37 attaquent pareillement un C.R.V. 39, chargé par la résistance 41 et sortant en 43.

Les sorties en 42 et 43 sont regroupées dans un troisième C.R.V. 44, pour fournir la sortie unique S en 46, ce C.R.V. étant chargé à son tour par la résistance 45.

Un circuit "en pyramide" tel que celui de la figure 5 est d'une grande souplesse, car il permet toutes les combinaisons d'amplificateurs possibles, garantissant toujours une sortie de signal utile en 46 tant qu'au moins un des amplificateurs 34 à 37 n'est pas en panne.

Comme il va de soi, l'invention n'est pas limitée à l'exemple de réalisation qui vient d'être décrit. C'est ainsi par exemple qu'il serait commode, dans le circuit de la figure 4, d'utiliser un déphaseur 12 variant par pas : o°, 90°, 180° uniquement, sur la voie 48 entre 7 et 13, et de prévoir, pour les valeurs intermédiaires du déphasage, un petit déphaseur 49, à variation continue, sur l'autre voie 48. Au lieu d'un coupleur RIBBLET 7 réalisé en guides d'ondes, il serait possible d'utiliser un coupleur semblable, mais réalisé soit en technique microruban, soit en technique coaxiale, ce type de coupleur étant aisément transposable dans l'une ou l'autre de ces deux techniques.

**Revendications**

1. Liaison de puissance pour signaux hyperfréquence, cette liaison étant protégée par redondance, en particulier par l'utilisation de plusieurs amplificateurs de puissance (32, 29) fonctionnant en redondance active, caractérisée en ce qu'elle comporte au moins :

   . un coupleur 3dB, 0° (24) apte à diviser le signal d'entrée à amplifier (E) en une ou plusieurs paires de signaux synchrones en fréquence et en phase ;
   . un circulateur d'adaptation (31, 28) suivi d'un amplificateur de puissance (32, 29) sur chacune des voies correspondant à chacun de ces signaux ; un déphaseur "0 ou π " (30) étant disposé sur l'une des voies de chaque paire avant le circulateur d'adaptation (31) ; et
   . un "Coupleur à Rang Variable" associé à chaque paire de voies en aval de ces deux amplificateurs (32, 29) qu'elle comporte et comprenant en cascade :

   - un coupleur d'entrée 3dB, 90° (7) dont les deux bornes d'entrée (1, 2) sont respectivement attaquées par les deux signaux provenant des sorties respectives de ces deux amplificateurs (32, 29) ;
   - un déphaseur réglable (12), apte à réaliser un déphasage allant de 0° à 180°, placé sur une des deux voies de sortie (47) de ce coupleur d'entrée (7) ; et
   - un coupleur de sortie 3dB, 90° (13) semblable ou identique au coupleur d'entrée (7) et dont les deux voies d'entrée (11, 10) sont respectivement attaquées par le signal de sortie de ce déphaseur réglable (12) et par le signal provenant de l'autre voie de sortie (48) du coupleur d'entrée (7), et dont une borne de sortie (3) est connectée sur une charge (6) tandis que l'autre borne de sortie (4) soit constitue la sortie de puissance (S) de la liaison, soit attaque à son tour une des deux bornes d'entrée d'un autre Coupleur à Rang Variable.

2. Liaison de puissance en hyperfréquence selon la revendication 1, caractérisée en ce que les coupleurs d'entrée (7) et de sortie (13) du Coupleur à Rang Variable sont des coupleurs du genre coupleurs RIBBLET.

3. Liaison de puissance selon l'une des revendications 1 ou 2, caractérisée en ce qu'un déphaseur "0° ou 180° " (30) est prévu sur une des voies d'attaque (25) de la paire d'amplificateurs redondants (32, 29).

4. Liaison de puissance selon l'une des revendications 1 à 3, caractérisée en ce que 1e déphaseur réglable (12) du Coupleur à Rang Variable est à trois positions prédéterminées : 0°, 90°, 180°, et en ce qu'un autre déphaseur (49), continûment réglable, est prévu sur l'autre voie (48) reliant les deux coupleurs (7, 13) de ce Coupleur à Rang Variable.

5. Liaison de puissance selon l'une des revendications 1 à 4, caractérisée en ce que le Coupleur à Rang Variable est réalisé en technique microruban.

6. Liaison de puissance selon l'une des revendications 1 à 4, caractérisée en ce que le Coupleur à Rang Variable est réalisé en technique coaxiale.

FIG 1

FIG 2

FIG 3

**FIG 4**

**FIG 5**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | DE-A-3 222 686 (ITALTEL)<br>* page 3, ligne 8 - page 4, ligne 9 * * page 10, lignes 4 - 12; figure 2 * | 1,2,4-6 | H 01 P 5/04<br>H 03 F 3/60<br>H 03 F 1/52 |
| A | ARCHIV DER ELEKTRISCHEN UBERTRAGUNG. vol. 24, no. 5, mai 1970, STUTTGART DE pages 205 - 207; H.-G.UNGER: "Breitbandrichtkoppler mit variabler Kopplung und Breitbandweichen mit kompaktem Phasenglied"<br>* page 206, colonne de gauche, lignes 15 - 32; figure 3 * | 2 | |
| A | US-A-4 701 716 (POOLE)<br>* colonne 2, ligne 37 - colonne 4, ligne 11 * * colonne 5, lignes 27 - 31 * * colonne 7, lignes 14 - 17; figures 1, 2 * | 1,2,6 | |
| A | US-A-4 010 426 (RAMBO)<br>* le document en entier * | 1,2 | |
| A | TELECOMMUNICATIONS AND RADIO ENGINEERING. vol. 37/38, no. 1, janvier 1983, WASHINGTON US pages 51 - 54; V.M.ANTONENKO et al.: "A high-power stripline adder and switch"<br>* page 51, lignes 1 - 18; figure 1 * | 3-5 | |
| A | US-A-4 016 503 (RAMBO)<br>* colonne 3, ligne 44 - colonne 4, ligne 20; figure 1 * | 5,6 | |

DOMAINES TECHNIQUES
RECHERCHES (Int. Cl.5)

H 01 P
H 03 F

Le présent rapport de recherche a été établi pour toutes les revendications

| Lieu de la recherche | Date d'achèvement de la recherche | Examinateur |
|---|---|---|
| La Haye | 17 mai 91 | DEN OTTER A.M. |